(19) **Europäisches Patentamt**

**European Patent Office**

**Office européen des brevets**

(11) Veröffentlichungsnummer: **0 312 694 B1**

(12) **EUROPÄISCHE PATENTSCHRIFT**

(45) Veröffentlichungstag der Patentschrift: 04.09.91

(51) Int. Cl.⁵: **C23C 14/56**, C23C 14/50, H01J 37/20

(21) Anmeldenummer: 88109520.2

(22) Anmeldetag: 15.06.88

(54) **Vorrichtung nach dem Karussell-Prinzip zum Beschichten von Substraten.**

(30) Priorität: 17.10.87 DE 3735284

(43) Veröffentlichungstag der Anmeldung:
26.04.89 Patentblatt 89/17

(45) Bekanntmachung des Hinweises auf die
Patenterteilung:
04.09.91 Patentblatt 91/36

(84) Benannte Vertragsstaaten:
CH DE FR GB IT LI

(56) Entgegenhaltungen:
EP-A- 0 136 562
DD-A- 241 090
US-A- 4 498 832
US-A- 4 592 306

(73) Patentinhaber: **LEYBOLD AKTIENGESELL-SCHAFT**
**Wilhelm-Rohn-Strasse 25**
**W-6450 Hanau am Main 1(DE)**

(72) Erfinder: **Anderle, Friedrich**
**Reichenberger Strasse 51**
**W-6450 Hanau/Main-1(DE)**
Erfinder: **Costescu, Dan Lucian**
**Friedhofstrasse 22N**
**W-6452 Hainburg(DE)**
Erfinder: **Kempf, Stefan**
**Freigerichter Strasse 53**
**W-8755 Alzenau(DE)**
Erfinder: **Novak, Emmerich**
**Windthorststrasse 1**
**W-6053 Obertshausen(DE)**
Erfinder: **Zejda, Jaroslav**
**Limesstrasse 11**
**W-6458 Rodenbach 1(DE)**

(74) Vertreter: **Zapfe, Hans, Dipl.-Ing.**
**Am Eichwald 7**
**W-6056 Heusenstamm 2 Rembrücken(DE)**

## Beschreibung

Die Erfindung betrifft eine Vorrichtung nach dem Karussell-Prinzip zum Beschichten von Substraten mit einer Vakuumkammer und einem in dieser angeordneten drehbaren Substrathalter, der in äquidistanter Verteilung und in kreisförmiger Anordnung mehrere Substrataufnahmen aufweist und durch den eine entsprechende Anzahl von Substraten mittels eines Antriebs schrittweise auf einer Kreisbahn von einer Schleusenstation über mindestens eine Beschichtungsstation zur Schleusenstation transportierbar ist.

Die Arbeitsweise einer solchen Vorrichtung kann wegen des Stillstandes zwischen den einzelnen Schritten, bedingt durch die Ein- und Ausschleusvorgänge sowie durch den stationären Beschichtungsvorgang als quasikontinuierlich bezeichnet werden.

Durch die US-PS 3 652 444 ist eine Vorrichtung der eingangs beschriebenen Gattung bekannt, die drei Beschichtungsstationen, aber nur eine Schleusenstation aufweist. Die bekannte Vorrichtung ist für die Herstellung von Halbleitern vorgesehen, und üblicherweise dienen hierbei die verschiedenen Beschichtungsstationen. zum Aufbringen einer ganzen Schichtenfolge. Den Beschichtungsstationen können andere Behandlungsstationen vor- und nachgeschaltet sein, in denen andere Behandlungsprozesse ablaufen, wie sie für die Vor- und Nachbehandlung von Halbleitern erforderlich sind. Bei gegebenem Teilkreisdurchmesser und entsprechenden Investitionskosten ist der Durchsatz jedoch begrenzt, schon weil das Ein- und das Ausschleusen einschließlich des Evakuierens der Schleusenkammer entsprechende Zeit benötigen.

Nun gibt es eine Reihe von Beschichtungsaufgaben bzw. Produkten, bei denen der Beschichtungsprozeß selbst und/oder die Vor- und/oder Nachbehandlungen einen geringeren Zeitaufwand bedingen, so daß der Einsatz der bekannten Vorrichtung für derartige Prozesse bzw. Produkte außerordentlich unwirtschaftlich wäre. Ein Beispiel für solche Produkte sind die sogenannten CD-Platten, die nur auf einer Seite mit einer einzigen Schicht aus einem rasch aufzubringenden hochglänzenden Metall wie beispielsweise Aluminium zu versehen sind.

Weiterhin von Bedeutung sind beim Betrieb derartiger Vorrichtungen die sogenannten Beladestationen, mit denen eine vollautomatische Be- und Entladung solcher Vorrichtungen möglich ist. Derartige Beladestationen sind in Verbindung mit den zugehörigen Magazinstationen verhältnismäßig aufwendig und ihre Taktfrequenz kann infolge der relativ langsamen Arbeitsweise der bekannten Vorrichtung nicht voll ausgenutzt werden.

Der Erfindung liegt daher die Aufgabe zugrunde, eine Vorrichtung der eingangs beschriebenen Gattung dahingehend zu verbessern, daß bei etwa vergleichbaren Investitionskosten der Durchsatz wesentlich gesteigert werden kann.

Die Lösung der gestellten Aufgabe erfolgt bei der eingangs angegebenen Vorrichtung erfindungsgemäß dadurch, daß die Vakuumkammer in Umfangsrichtung des drehbaren Substrathalters zwei Schleusenstationen und zwei Beschichtungsstationen jeweils hintereinander aufweist, und daß die Schrittweite des Antriebs einerseits und die Winkelstellung jeder Beschichtungsstation zu der ihr zugeordneten Schleusenstation in Bezug auf die Drehachse des Substrathalters andererseits so gewählt sind, daß ein und dieselbe Beschichtungsstation über die schrittweise Bewegung jeweils einer bestimmten Substrataufnahme jeweils ein und derselben Schleusenstation zugeordnet ist.

Im Prinzip wird durch die Doppelanordnung von Schleusenstationen und Beschichtungsstationen erreicht, daß zwei Folgen von Substraten in alternierender Reihenfolge durch die Vorrichtung transportiert werden, wobei aber jeweils zwei Substrate gleichzeitig, d.h. im Parallelbetrieb beschichtet und auch die Schleusenstationen gleichzeitig, d.h. im Parallelbetrieb, betätigt werden, und zwar jeweils während des Stillstandes des Substrathalters zwischen zwei Transportschritten. Eine solche Vorrichtung und ihre Betriebsweise ermöglichen infolgedessen nahezu eine Verdoppelung des Durchsatzes bei nur unwesentlich höheren Investitionskosten, bedingt durch die Doppelanordnung von Schleusen- und Beschichtungsstationen.

Es ist dabei zur Vereinfachung der Steuerung einer solchen Vorrichtung ganz besonders vorteilhaft, wenn die in der in Transportrichtung vordersten Beschichtungsstation beschichteten Substrate durch die in Transportrichtung gleichfalls vorderste Schleusenstation und die in der in Transportrichtung hintersten Beschichtungsstation beschichteten Substrate durch die jeweils hinterste Schleusenstation ein- und ausschleusbar sind.

Die erfindungsgemäße Zuordnung von Schleusenstationen einerseits und Beschichtungsstationen andererseits erfolgt durch die Abstimmung der Schrittweite des Antriebs einerseits und des Teilungswinkels für die Substrataufnahmen andererseits. Bei der Verdoppelung von Beschichtungs- und Schleusenstationen wird daher zweckmäßig so vorgegangen, daß die Schrittweite des Antriebs doppelt so groß ist wie der Teilungswinkel für die Substrataufnahmen.

In ganz besonders zweckmäßiger Weise wird dabei der als Karussell wirkende Substrathalter mit insgesamt vierundzwanzig Substrataufnahmen versehen, so daß der Teilungswinkel 15 Grad beträgt. Die Schrittweite des Antriebs beträgt infolgedessen 30 Winkelgrade. In einem solchen Falle kann vorteilhaft der Abstand der Schleusenstationen voneinander 45 Winkelgrad und der Abstand der Beschichtungsstationen voneinander 75 Winkelgrad betragen. Der größere Abstand der Beschichtungsstationen voneinander ist darauf zurückzuführen, daß diese in aller Regel einen größeren Durchmesser aufweisen.

Auf die angegebene Weise erfolgt die Aufteilung der an sich in einer ununterbrochenen Reihe im Substrathalter untergebrachten Substrate in zwei alternierende Folgen von Substraten, die jeweils durch unterschiedliche Schleusenstationen einerseits und unterschiedliche Beschichtungsstationen andererseits ein- und ausgeschleust bzw. beschichtet werden.

Es ist gemäß einer weiteren Ausgestaltung der Erfindung besonders vorteilhaft, wenn die Schleusenstationen ein in senkrechter Richtung abgedichtet gegenüber der Vakuumkammer bewegliches Schleusenkammer-Oberteil mit einem zylindrischen Innenraum und mit je einer waagrechten oberen und unteren Dichtfläche aufweist, ferner einen angetrieben, dem Oberteil zugeordneten und dessen Innenraum weitgehend ausfüllenden Verdrängerkörper mit einem an seiner Oberkante befindlichen umlaufenden und beim Absenken auf die obere Dichtfläche des Oberteils aufsetzbaren Dichtrand, wobei die untere Dichtfläche des Oberteils nachfolgend abgedichtet auf der Oberseite des Substrathalters absetzbar ist, weiterhin ein in senkrechter Richtung abgedichtet gegenüber der Vakuumkammer bewegliches, zum Oberteil koaxiales Schleusenkammer-Unterteil mit einer oberen Dichtfläche, die abgedichtet an die Unterseite des Substrathalters anpreßbar ist, derart, daß bei abgehobenen Verdrängerkörper der Raum zwischen Substrathalter und Vakuumkammer gegenüber der Umgebungsluft abgedichtet ist, bei abgesenkten Verdrängerkörper und evakuierter Schleusenkammer hingegen der Substrathalter frei gegenüber den Dichtflächen von Oberteil und Unterteil beweglich ist.

Von ganz besonderem Vorteil ist hierbei der Verdrängerkörper, der allein durch sein Eindringen in das Schleusenkammer-Oberteil die zunächst dort vorhandene Umgebungsluft größtenteils verdrängt und damit die Evakuierungszeit drastisch reduziert. Die Steuerfunktion für die Bewegung des Schleusenkammer-Oberteils mit seiner Dichtfläche gegenüber dem Substrathalter wird durch einen gesonderten Antrieb für das Schleusenkammer-Oberteil bewirkt, der zwischen dem Flansch und der Vakuumkammer angeordnet ist.

Eine wiederum besonders vorteilhafte Weiterbildung des Erfindungsgegenstandes ist dadurch gekennzeichnet, daß die Beschichtungsstation eine auf der Vakuumkammer angeordnete Kathodenkammer mit einer Zerstäubungskathode mit einem Target aufweist, dessen Zerstäubungsfläche (in an sich bekannter Weise) dem Substrathalter zugekehrt ist, daß zwischen dem Target und dem Substrathalter ein Maskenträger mit einer Maske angeordnet ist, und daß unterhalb der Vakuumkammer eine Hubeinrichtung mit einer dem Kammerboden abgedichtet durchdringenden Hubstange angeordnet ist, durch die das Substrat mittels der Substrataufnahme konzentrisch an die Maske anpreßbar ist.

Weitere vorteilhafte Ausgestaltungen des Erfindungsgegenstandes ergeben sich aus den übrigen Unteransprüchen.

Ein Ausführungsbeispiel des Erfindungsgegenstandes wird nachfolgend anhand der Figuren 1 bis 7 näher erläutert.

Es zeigen:

Figur 1   eine Draufsicht auf eine vollständige Vorrichtung nach der Erfindung,

Figur 2   eine Voransicht des Gegenstandes von Figur 1 in Richtung des Pfeils II,

Figur 3   einen Vertikalschnitt durch eine der Schleusenstationen in vergrößertem Maßstab,

Figur 4   einen teilweisen Vertikalschnitt durch eine der Beschichtungsstationen,

Figur 5   einen Teilausschnitt aus Figur 4 in vergrößertem Maßstab und mit zusätzlichen Details,

Figur 6   eine Draufsicht auf den unteren Teil von Figur 5 in Richtung des Pfeils VI und

Figur 7   eine Draufsicht auf den Substrathalter.

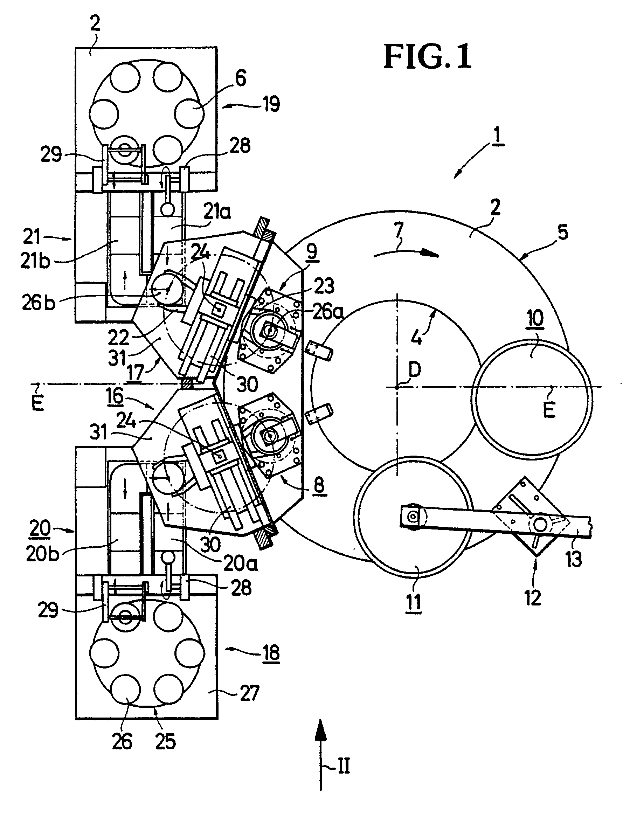

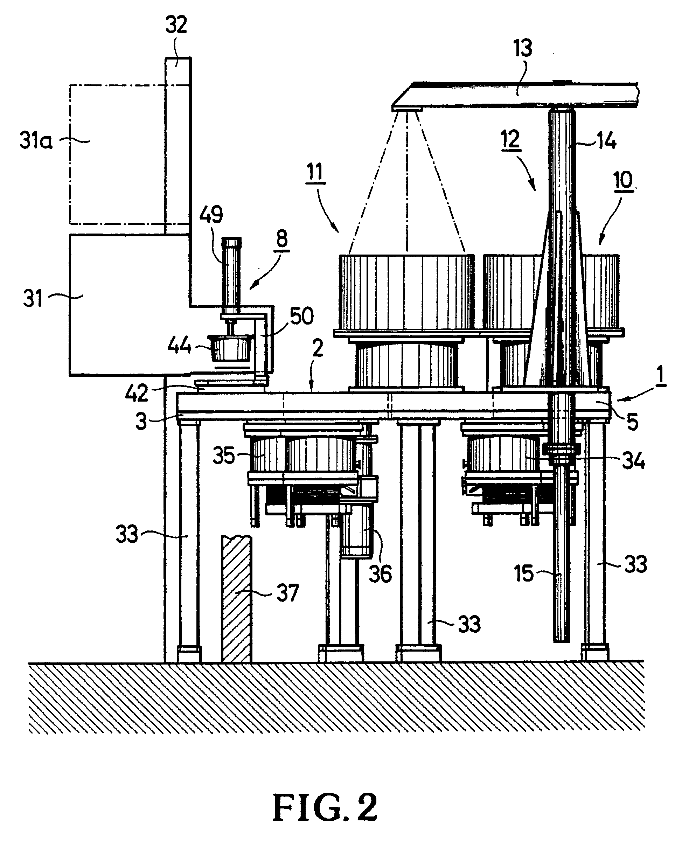

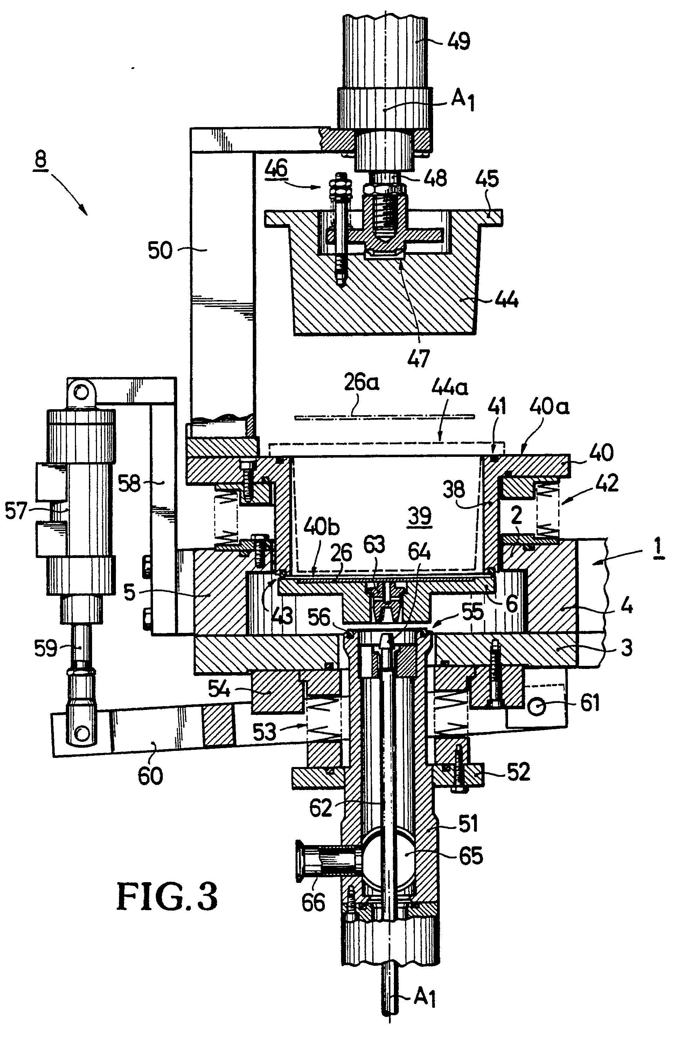

In Figur 1 ist eine Vakuumkammer 1 dargestellt, deren äußere Hüllfläche als durch einen flachen Hohlzylinder gebildet beschrieben werden kann, d.h. eine obere kreisringförmige Kammerdecke 2 und ein kongruenter kreisringförmiger Kammerboden 3 sind durch eine innere Zarge 4 und eine äußere Zarge 5 miteinander verbunden. Die sehr flachen Abmessungen der Vakuumkammer 1 gehen insbesondere aus Figur 2 hervor. Im Innern der Vakuumkammer 1 ist ein gleichfalls kreisringförmiger Substrathalter 6 drehbar und angetrieben untergebracht, worauf im Zusammenhang mit den Figuren 3 bis 7 noch näher eingegangen wird. Die Anordnung muß jedoch nicht im Grundriß einem Kreisring entsprechen; vielmehr kann die Vakuumkammer auch zylindrisch ausgebildet sein.

Die Transportrichtung der Substrate wird durch den Pfeil 7 angedeutet.

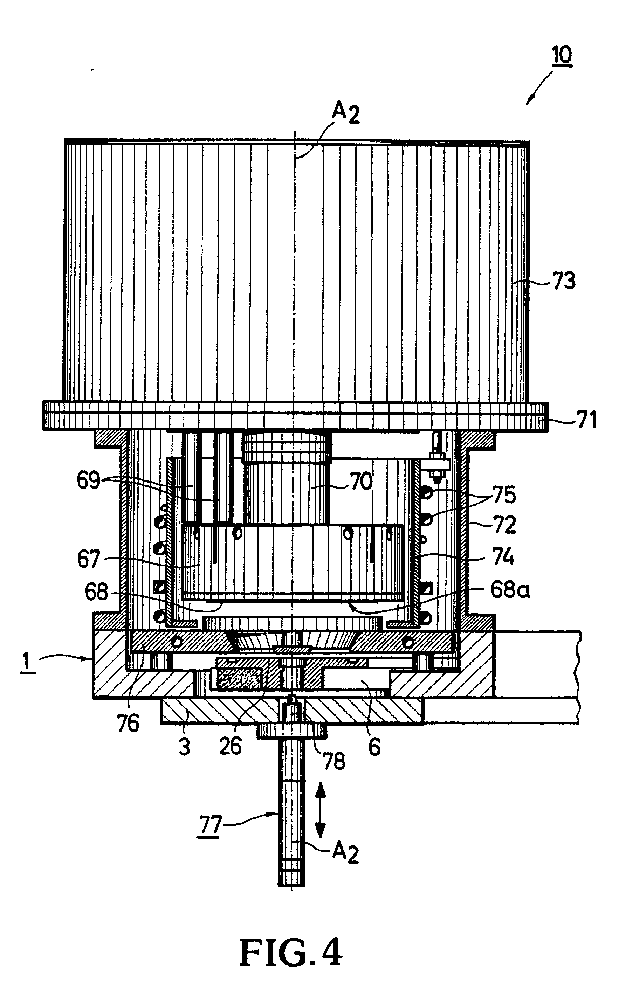

Die Vakuumkammer 1 ist mit zwei identischen Schleusenstationen 8 und 9 ausgestattet, auf die im Zusammenhang mit Figur 3 im Detail eingegangen wird. Auf der Oberseite der Vakuumkammer sind ferner zwei Beschichtungsstationen 10 und 11 angeordnet, auf die im Zusammenhang mit den Figuren 4 bis 6 noch im Detail eingegangen werden wird.

Den Beschichtungsstationen 10 und 11 ist ein Hubmechanismus 12 zugeordnet, der aus einem schwenkbaren Ausleger 13, einem Führungsrohr 14 und einem Hubzylinder 15 besteht und einen Wechsel der Kathoden ermöglichen soll.

Es versteht sich, daß sich die angegebenen Teilungswinkel jeweils auf die vertikalen Mittenachsen der Schleusenstationen und der Beschichtungsstationen bzw. der Substrataufnahmen und der Substrate beziehen.

Wie insbesondere in der Draufsicht in Figur 1 sichtbar wird, ist jeder Schleusenstation 8 bzw. 9 eine Beladestation 16 bzw. 17 und eine Magazinstation 18 bzw. 19 zugeordnet. Zwischen jeder Beladestation und jeder Magazinstation ist eine Übergabeeinrichtung 20 bzw. 21 mit zwei parallelen Einbahn-Transportstraßen 20a/20b bzw. 21a/21b angeordnet.

Jede Beladestation weist jeweils zwei Greifer 22 und 23 auf, die in diametral entgegengesetzten Richtungen an einer gemeinsamen Drehachse 24 befestigt sind. Die Drehachse 24 befindet sich in einer solchen Lage zur Übergabeeinrichtung 20 bzw. 21 einerseits und zur Schleusenstation 8 bzw. 9 andererseits, daß mittels des einen Greifers 23 ein oberhalb der Schleusenstation 8 bzw. 9 befindliches Substrat 26a und mittels des anderen Greifers 22 gleichzeitig ein oberhalb der Übergabeeinrichtung befindliches Substrat 26b wahlweise erfaßbar oder absetzbar ist.

Jede Magazinstation 18 bzw. 19 besitzt ein als Magazinrevolver ausgebildetes Magazin 25, in dem jeweils sechs Stapel von Substraten 26 untergebracht sind. Jedes Magazin ist wieder in einem Magazintisch 27 untergebracht. Zur Magazinstation 18 bzw. 19 gehört noch eine Wendeeinrichtung 28 und eine Ablegeeinrichtung 29.

Im Hinblick auf die Drehbewegung der Greifer 22 und 23 sind deren Drehachse 24 noch jeweils zwei Stoßdämpfer 30 zugeordnet. Die Beladestationen 16 und 17 sind von Schutzhauben 31 umgeben, und die gesamte Anordnung ist im Hinblick auf eine vertikale Symmetrieebene E-E (Figur 1) spiegelsymmetrisch ausgebildet.

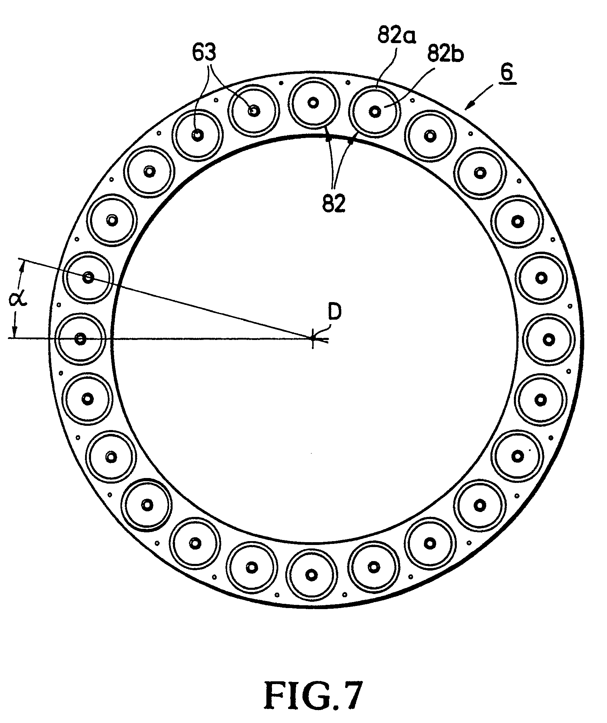

Wie aus Figur 2 noch ergänzend hervorgeht, sind die Schutzhauben 31 mit Hilfe von Führungsschienen 32 aus der ausgezogen dargestellten Position in die strichpunktiert dargestellte Position 31a anhebbar, um den Zugang zur Beladestation zu ermöglichen. Die Vakuumkammer 1 ruht auf Stützen 33. An die Vakuumkammer 1 sind Turbomolekularpumpen 34 und 35 angeschlossen, und für den schrittweisen Antrieb des in Figur 7 gezeigten Substrathalters 6 ist ein Antriebsmotor 36 vorgesehen.

Der Wandabschnitt 37 steht symbolisch für die Begrenzungswand eines Sauberraums.

In Figur 3 sind Einzelheiten der Vakuumkammer 1 deutlicher erkennbar, nämlich die Kammerdecke 2, der Kammerboden 3 und die Zargen 4 und 5. In der Kammerdecke 2 ist eine zylindrische Ausnehmung angeordnet, die mit ausreichendem Radialspiel von einem Schleusenkammer-Oberteil 38 durchdrungen wird. Dieses besitzt einen zylindrischen Innenraum 39 und am oberen Ende einen Flansch 40 mit einer Dichtfläche 40a, in die ein Dichtring 41 eingelegt ist. Das Oberteil 38 ist über einen Faltenbalg 42 vakuumdicht mit der Vakuumkammer 1 verbunden.

Das Schleusenkammer-Oberteil 38 besitzt außerdem eine untere Dichtfläche 40b, in die ein weiterer Dichtring 43 eingelegt ist.

Zur Schleusenstation 8 bzw. 9 gehört ferner ein dem Schleusenkammer-Oberteil 38 zugeordneter, angetriebener und den zylindrischen Innenraum 39 weitgehend ausfüllender Verdrängerkörper 44 mit einem Dichtrand 45. Der Verdrängerkörper ist über eine Verstelleinrichtung 46 mit einer Kugelpaarung 47 mit einer Kolbenstange 48 verbunden, die zu einem Antriebszylinder 49 gehört. Dieser ist seinerseits über eine Tragsäule 50 mit dem Flansch 40 verbunden, so daß eine einwandfreie Zentrierung des Verdrängerkörpers 44 in Bezug auf die Achse $A_1$-$A_1$ der gesamten Schleusenstation gewährleistet ist. Mittels des Antriebszylinders 49 ist der Dichtrand 45 auf die obere Dichtfläche 40a bzw. den Dichtring 41 des Schleusenkammer-Oberteils vakuumdicht aufsetzbar.

Zwischen dem Flansch 40 und der Vakuumkammer 1 ist noch ein hier nicht sichtbarer Antrieb vorhanden, durch den die untere Dichtfläche 40b des Oberteils 38 abgedichtet auf der Oberseite des Substrathalters 6 abgesetzt wird.

Weiterhin besitzt die Schleusenstation 8 bzw. 9 ein Schleusenkammer-Unterteil 51, das als rohrförmiger Hohlkörper ausgebildet ist und einen Befestigungsflansch 52 für einen weiteren Faltenbalg 53 besitzt, der das Unterteil 51 konzentrisch umgibt und dieses vakuumdicht mit dem Kammerboden 3 verbindet. Zum Anschluß an den Kammerboden dient ein Überwurfring 54.

Das Unterteil 51 besitzt eine obere Dichtfläche 55, in die gleichfalls ein Dichtring 56 eingelegt ist. Unter Zwischenschaltung des Faltenbalges 53 ist das Unterteil 51 in Richtung der Achse $A_1$-$A_1$ begrenzt beweglich durch den Kammerboden 3 hindurchgeführt. Die koaxiale Vertikalbewegung wird durch einen Antriebszylinder 57 bewirkt, der über eine Tragsäule 58 an der Vakuumkammer 1 befestigt ist, und dessen Kolbenstange 59 auf das eine Ende einer gabelförmigen Schwinge 60 einwirkt, deren anderes Ende über eine Gelenkachse 61 mit dem Kammerboden 3 verbunden ist. Zwischen dem Angriffspunkt der Kolbenstange 59 und der Gelenkachse 61 ist die Schwinge 60 über eine weitere, hier nicht dargestellte Gelenkverbindung mit dem Schleusenkammer-Unterteil 5 verbunden, so daß bei einer Betätigung des Antriebszylinders 57 das Unterteil 51 angehoben oder abgesenkt werden kann.

Im Innern des Schleusenkammer-Unterteils 51 befindet sich in koaxialer Anordnung eine Hubstange 62, die nach oben über die Dichtfläche 55 hinaus anhebbar und in Eingriff mit einer Substrataufnahme 63 bringbar ist, die in eine konzentrische Bohrung des Substrats 26 eingreift. Mittels der Hubstange 62 und der Substrataufnahme 63 läßt sich das Substrat zwischen der ausgezogen dargestellten Position 26 und der strichpunktiert dargestellten Position 26a bewegen. In der zuerst genannten Stellung ruht das Substrat 26 in einer flachen zylindrischen Ausnehmung des Substrathalters 6, wobei sich die Substrataufnahme 63 mittels eines nicht näher bezeichneten Flansches auf einer gleichfalls nicht näher bezeichneten Tragschulter des Substrathalters 6 abstützt. In dieser Position läßt sich das Substrat 26 schrittweise durch die Vakuumkammer 1 hindurch transportieren. Die Verbindung der Hubstange 62 mit der Substrataufnahme 63 erfolgt beim Anheben der Hubstange 62 mittels eines Zentrierkegels 64, der in eine komplementäre Bohrung der Substrataufnahme 63 eingreift. Die obere Position 26a des Substrats ist diejenige Position, in der das Substrat in die Achse $A_1$-$A_1$ eingeschwenkt und aus dieser wieder mittels der Greifer 22 bzw. 23 herausgeschwenkt werden kann (siehe Figur 1).

Das Schleusenkammer-Unterteil 51 ist über einen Saugstutzen 65 an eine Vakuumpumpe angeschlossen und über eine Flutleitung 66 belüftbar.

Zu Figur 3 wäre noch nachzutragen, daß die eingezeichneten Stellungen von Verdrängerkörper 44 einerseits und Schleusenkammer-Oberteil 38 und Schleusenkammer-Unterteil 51 andererseits während des Betriebes nicht gleichzeitig auftreten. Die eingezeichnete Stellung von Oberteil 38 und Unterteil 51 relativ zum Substrathalter 6 ist nur möglich, wenn sich der Verdrängerkörper 44 in der gestrichelten Position befindet, d.h. abgedichtet gegenüber dem Oberteil 38. Wenn sich der Verdrängerkörper 44 umgekehrt in der angehobenen Position 44 befindet, müssen die Dichtflächen 40b und 55 am Substrathalter 6 anliegen, um das Eindringen von Umgebungsluft in die Vakuumkammer 1 zu verhindern.

Die Figuren 4, 5 und 6 zeigen alle wesentlichen Einzelheiten einer Beschichtungsstation 10 bzw. 11. Wesentliches Element einer solchen Beschichtungsstation ist eine Zerstäubungskathode 67, die bevorzugt als sogenannte Magnetronkathode ausgeführt und auf dem Markt erhältlich ist. Von dieser Zerstäubungskathode ist hier im wesentlichen nur die sogenannte Dunkelraumabschirmung erkennbar, sowie ein sogenanntes Target 68, das aus der unteren Stirnseite der Dunkelraumabschirmung herausragt und mit seiner Zerstäubungsfläche 68a dem Substrathalter 6 bzw. dem Substrat 26 zugekehrt ist, das sich in der in Figur 3 gezeigten Weise im Substrathalter 6 befindet.

Die Zerstäubungskathode 67 ist über Kühlmittelleitungen 69 und eine Tragsäule 70, in der sich auch die elektrische Zuleitung zur Kathode befindet, mit einem Tragflansch 71 verbunden, der sich über ein Kathodenkammer-Unterteil 72 auf der Vakuumkammer 1 abstützt. Auf dem Tragflansch 71 ruht weiterhin ein Kathodenkammer-Oberteil 73, in dem die erforderlichen Zuleitungen etc. untergebracht sind.

Zwischen der rotationssymmetrischen Zerstäubungskathode 67 und dem zylindrischen Unterteil 72 befindet sich noch eine sogenannte Innenkammer 74, die von einer Kühlschlange 75 umgeben ist und zur Führung des Zerstäubungsgases im Bereich der Kathode 67 dient.

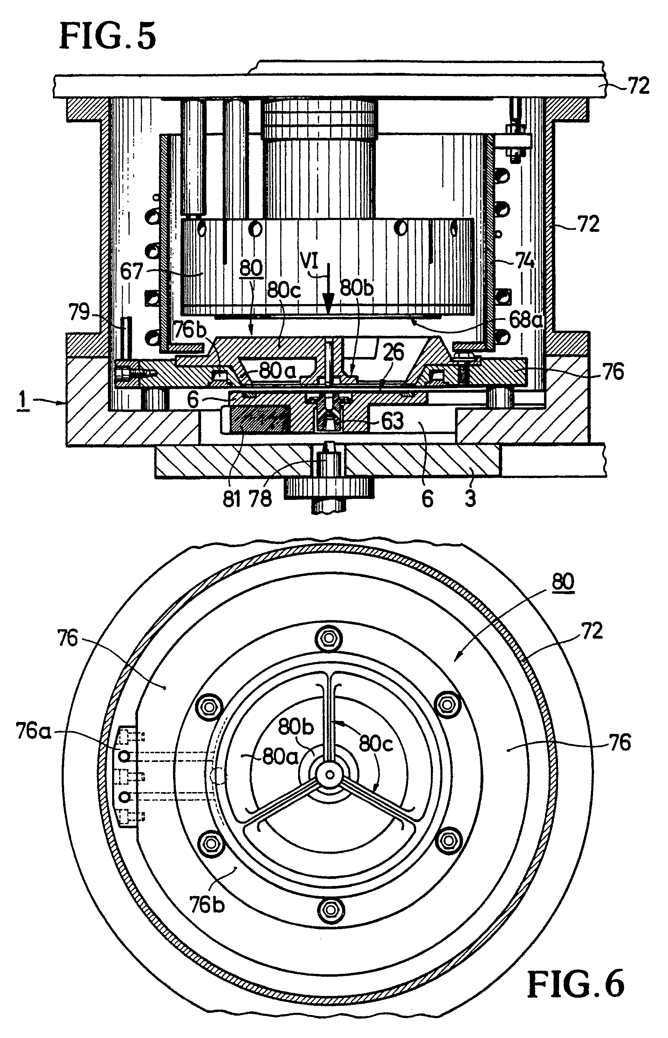

Zwischen der Zerstäubungsfläche 68a und dem Substrat 26 befindet sich noch ein Maskenträger 76, auf den im Zusammenhang mit den Figuren 5 und 6 noch näher eingegangen wird. Die gesamte Beschichtungsstation ist im Hinblick auf eine vertikale Achse $A_2$-$A_2$ rotationssymmetrisch ausgebildet, und unter dem Kammerboden 3 befindet sich - gleichfalls koaxial zur Achse $A_2$-$A_2$ eine weitere Hubeinrichtung 77, die in analoger Weise zu Figur 3 eine Hubstange 78 besitzt. Die Anordnung ist dabei so getroffen, daß die Hubstange 78 den Kammerboden 3 vakuumdicht durchdringt.

Anhand der Figuren 5 und 6 soll nun im wesentlichen der Aufbau und die Wirkungsweise der Maske beschrieben werden. In dem bereits genannten Maskenträger 76, der mit einem Anschlußelement 76a für eine Kühlmittelleitung 79 und mit einem konzentrischen Kühlmittelkanal 76b ausgestattet ist, ist konzentrisch eine Maske 80 angeordnet, die aus einer Außenmaske 80a und aus einer hierzu konzentrischen Innenmaske 80b besteht. Die beiden Maskenteile sind durch radial verlaufende, äquidistant angeordnete Speichen 80c miteinander verbunden. Die Außenmaske 80a besitzt eine untere Kreisringfläche, und die Innenmaske 80b besitzt eine hierzu konzentrische untere Kreisfläche, die in der gleichen Ebene angeordnet ist, wie die untere Kreisringfläche der Außenmaske 80a. Gegenüber dieser Ebene sind die Speichen 80c nach oben deutlich zurückgesetzt. Sobald das Substrat 26 in die in Figur 5 dargestellte Position gelangt ist, wird das Substrat 26 mittels der Hubstange 78 und der Substrataufnahme 63 angehoben und gegen die unteren Flächen der Maske 80 gepreßt. Sobald diese Stellung des Substrats erreicht wird, wird die Zerstäubungskathode 67 eingeschaltet, so daß die nicht von der Außenmaske 80a und der Innenmaske 80b abgedeckte Kreisringfläche des Substrats 26 mit dem Material des Targets 68 (oder einem Reaktionsprodukt dieses Targetmaterials) beschichtet wird. Durch die zurückgesetzte Anordnung der Speichen 80c bewirken diese jedenfalls keinen merklichen Abschattungseffekt. Die Maske 80 wird jedenfalls durch den Maskenträger 76 wirksam gekühlt, so daß sie durch die beim Beschichtungsvorgang übertragene Wärme nicht beschädigt wird.

Figur 5 ist noch zu entnehmen, daß der Substrathalter 6 an seinem Außenumfang einen Zahnkranz 81 besitzt, in den ein hier nicht gezeigtes Ritzel des Antriebsmotors 36 (Figur 2) eingreift. Dieser Substrathalter ist im übrigen in der Draufsicht in Figur 7 gezeigt: Der Substrathalter 6 nach Figur 7 ist in der Draufsicht kreisringförmig ausgebildete, im Querschnitt jedoch etwa T-förmig, wie dies aus den Figuren 3 und 4 hervorgeht. In der Oberseite des Substrathalters 6 befinden sich, mit ihren Achsen auf einem Teilkreis liegend, 24 flache Ausnehmungen 82 mit einem kreisförmigen Umriß eines solchen Durchmessers, daß die Substrate 26 gerade eben mit ausreichendem Spiel eingelegt werden können. Im Randbereich weisen die Ausnehmungen 82 eine Ringnut 82a auf, die eine Kreisringfläche 82b umgibt. Im Zentrum einer jeden Ausnehmung 82 befindet sich - vertikal beweglich - je eine Substrataufnahme 63, die als Rotationskörper ausgebildet und in den Figuren 3 und 5 im Schnitt dargestellt ist. Durch die Unterbringung von insgesamt 24 Ausnehmungen 82 und Substrataufnahmen 63 beträgt der sogenannte Teilungswinkel $\alpha$ in Bezug auf die Drehachse D des Systems 15 Grad, wobei es sich versteht, daß bei einer anderen Anzahl von Ausnehmungen 82 dieser Teilungswinkel entsprechend andere Werte haben kann. Nach diesem Teilungswinkel $\alpha$ bestimmt sich jedoch die Schrittweite für die Fortschaltung des Substrathalters 6, sowie die Anordnung von Schleusen- und Beschichtungsstationen. So beträgt der Abstand der Schleusenstationen 8 bzw. 9 und der Abstand der Beschichtungsstationen 10 bzw. 11 - jeweils untereinander - in Umfangsrichtung ein ungeradzahliges Vielfaches des Teilungswinkels $\alpha$. Dadurch,daß die Schrittweite des Antriebs 36 doppelt so groß ist wie der Teilungswinkel für die Substrataufnahmen 63, werden die bereits beschriebenen zwei alternierend angeordneten Folgen von Substraten geschaffen. Ganz besonders zweckmäßig haben dabei die beiden Schleusenstationen 8 und 9 voneinander einen Winkelabstand von 3 Teilungswinkeln, und die beiden Beschichtungsstationen 10, 11 haben voneinander einen Winkelabstand von 5 Teilungswinkeln. Weiterhin befinden sich zwischen der in Transportrichtung letzten Beschichtungsstation 11 und der in Transportrichtung ersten Schleusenstation 8 ein Winkelabstand von fünf Teilungswinkeln. Dadurch wird erreicht, daß zwischen der in Transportrichtung letzten Schleusenstation 9 und der in Transportrichtung ersten Beschichtungsstation 10 ein entsprechend langer Weg von elf Teilungswinkeln vorhanden ist, der für die Vorbehandlung der Substrate sehr nützlich ist. Dadurch haben einmal die beiden alternierenden Substratfolgen jeweils in etwa die gleiche Verweilzeit im Vakuum. Diese Verweilzeit bewirkt beispielsweise bei Kunststoffsubstraten, wie sie für die Herstellung von CD-Platten in Frage kommen, eine hinreichende Ausgasung. Weiterhin ist es möglich, für den Fall etwa notwendigwerdender Vorbehandlungen der Substrate auf diesem relativ langen Transportweg weitere Behandlungsstationen unterzubringen, beispielsweise Glimmstationen für die Plasmabehandlung der Substrate.

Die Wirkungsweise der Vorrichtung sei im Zusammenhang nochmals erläutert:

Der Substrathalter 6 wird mittels der beiden Schleusenstationen 8 und 9 mit Substraten 26 beschickt, und zwar wird mittels der Schleusenstation 8 jeweils die erste, dritte, fünfte, siebte, ... Ausnehmung mit einem Substrat bestückt, während mittels der Schleusenstation 9 die zweite, vierte, sechste, achte, ... Ausnehmung 82 mit einem Substrat bestückt wird. Die in den ungeradzahligen Ausnehmungen einerseits und in den geradzahligen Ausnehmungen andererseits liegenden Substrate bilden jeweils eine Folge. Das Einlegen der Substrate geschieht dadurch, daß jeweils ein Greifer 22 ein Substrat von der jeweils zugehörigen Übergabeeinrichtung 20 bzw. 21 übernimmt und es nach dem Herumschwenken um die Drehachse 24 in die in Figur 3 gestrichelt dargestellte Position 26a bringt. In dieser Stellung eines jeden Substrats dringt die Substrataufnahme 63, angehoben durch die Hubstange 62, mittels eines ringförmigen Fortsatzes von unten in eine kreisförmige Mittenausnehmung des Substrats ein und hält dieses zuverlässig fest. In diesem Augenblick gibt der betreffende Greifer der Beladestation das Substrat frei, das nunmehr durch eine Absenkbewegung der Hubstange 62 in die in Figur 3 ausgezogen dargestellte Position 26 gebracht wird. Unmittelbar, nachdem das Substrat 26 zur Auflage in der Ausnehmung 82 des Substrathalters 6 kommt, setzt sich auch die Substrataufnahme 63 auf der Ringschulter des Substrathalters 6 ab, und der Zentrierkegel 64 trennt sich von der Substrataufnahme 63. Es versteht sich, daß hierbei - im Gegensatz zur zeichnerischen Darstellung in Figur 3 - eine Abdichtung zwischen dem Substrathalter 6 und dem Schleusenkammer-Oberteil 38 einerseits und dem Schleusenkammer-Unterteil 51 andererseits besteht. Unmittelbar nach dem Absenken des Substrats 26 wird der Verdrängerkörper 44 in den Innenraum 39 oberhalb des Substrats 26 eingeführt (gestrichelt dargestellte Position), wobei sich eine Abdichtung zwischen der Dichtfläche 40a und dem Dichtrand 45 ergibt. Nunmehr werden - unter ständigem Betrieb der Vakuumpumpen - das Schleusenkammer-Oberteil 38 angehoben und das Schleusenkammer-Unterteil 51 abgesenkt. Diese Stellung ist in Figur 3 dargestellt. Jetzt ist die Vorrichtung in einem Betriebszustand in der der Substrathalter 6 um eine Schrittweite, d.h. um 2 Teilungswinkel, fortgeschaltet werden kann.

Sobald das betreffende Substrat im Zuge seiner schrittweisen Fortschaltung in die Beschichtungsstation 10 gemäß den Figuren 4 bis 6 gelangt und dort zum Stillstand gekommen ist, wird das Substrat 26 mittels der dort vorgesehenen Hubstange 78 von unten gegen die Maske 80 gepreßt, ein Vorgang, der bereits weiter oben beschrieben wurde. In dieser Anpreßstellung wird die Kreisringfläche des Substrats 26 zwischen der Außenmaske 80a und der Innenmaske 80b mit dem vom Target 68 stammenden Material beschichtet. Nach Beendigung des Beschichtungsvorganges wird das Substrat 26 wieder in die abgesenkte Position innerhalb der Ausnehmung 82 gebracht, wobei sich auch die Hubstange 78 von der Substrataufnahme 83 trennt (Figuren 4 und 5). Es ist jetzt erneut möglich, den Substrathalter 6 schrittweise fortzuschalten, bis das fertig beschichtete Substrat wieder in die gleiche Schleusenstation 8 gelangt. Der Ausschleusvorgang des Substrats erfolgt genau umgekehrt wie der Einschleusvorgang, d.h. zunächst wird der Substrathalter 6 gegenüber dem Schleusenkammer-Oberteil 38 und dem Schleusenkammer-Unterteil 51 abgedichtet, danach der Innenraum 39 geflutet und der Verdrängerkörper 44 angehoben. Unmittelbar nachfolgend wird auch das Substrat 26 mittels der Hubstange 62 in die strichpunktierte Position 26a angehoben und von einem der Greifer 22 bzw. 23 erfaßt und aus dem Bereich um die Achse A₁-A₁ herausgeschwenkt. Wiederum unmittelbar nachfolgend wird ein neues, noch unbeschichtetes Substrat durch Drehung der Greifer um die Drehachse 24 in die gleiche Position eingeschwenkt, worauf sich der Einschleusvorgang in der weiter oben beschriebenen Weise wiederholt.

**Patentansprüche**

1. Vorrichtung nach dem Karussell-Prinzip zum Beschichten von Substraten mit einer Vakuumkammer und einem in dieser angeordneten drehbaren Substrathalter, der in äquidistanter Verteilung und in kreisförmigen Anordnung mehrere Substrataufnahmen aufweist und durch den eine entsprechende Anzahl von Substraten mittels eines Antriebs schrittweise auf einer Kreisbahn von einer Schleusenstation über mindestens eine Beschichtungsstation zu Schleusenstation transportierbar ist, dadurch gekennzeichnet, daß die Vakuumkammer (1) in Umfangsrichtung des drehbaren Substrathalters (6) zwei Schleusenstationen (8, 9) und zwei Beschichtungsstationen (10, 11) jeweils hintereinander aufweist, und daß die Schrittweite des Antriebs (36) einerseits und die Winkelstellung jeder Beschichtungsstation (10 bzw. 11) zu der ihr zugeordneten Schleusenstation (8 bzw. 9) in Bezug auf die Drehachse des Substrathalters (6) andererseits so gewählt sind, daß ein und dieselbe Beschichtungsstation (10 bzw. 11) über die schrittweise Bewegung jeweils einer bestimmten Substrataufnahme (63) jeweils ein und derselben Schleusenstation (8 bzw. 9) zugeordnet ist.

2. Vorrichtung nach Anspruch 1, dadurch gekennzeichnet, daß die in der in Transportrichtung vordersten Beschichtungsstation (10) beschichteten Substrate durch die in Transportrichtung gleichfalls vorderste Schleusenstation (8) und die in der in Transportrichtung hintersten Beschichtungsstation (11) beschichteten Substrate durch die jeweils hinterste Schleusenstation (9) ein- und ausschleusbar sind.

3. Vorrichtung nach Anspruch 1, dadurch gekennzeichnet, daß die Schrittweite des Antriebs (36) doppelt so groß ist wie der Teilungswinkel für die Substrataufnahmen

4. Vorrichtung nach Anspruch 3, dadurch gekennzeichnet, daß der Abstand der Schleusenstationen (8, 9) untereinander in Umfangsrichtung ein ungeradzahliges Vielfaches des Teilungswinkels ist.

5. Vorrichtung nach Anspruch 3, dadurch gekennzeichnet, daß der Abstand der Beschichtungsstationen (10, 11) untereinander in Umfangsrichtung ein ungeradzahliges Vielfaches des Teilungswinkels ist.

6. Vorrichtung nach Anspruch 1, dadurch gekennzeichnet, daß die beiden Schleusenstationen (8, 9) voneinander einen Winkelabstand von drei Teilungswinkeln haben.

7. Vorrichtung nach Anspruch 1, dadurch gekennzeichnet, daß die beiden Beschichtungsstationen (10, 11) voneinander einen Winkelabstand von fünf Teilungswinkeln haben.

8. Vorrichtung nach Anspruch 1, dadurch gekennzeichnet, daß zwischen der in Transportrichtung letzten Beschichtungsstation (11) und der in Transportrichtung ersten Schleusenstation (8) ein Winkelabstand von fünf Teilungswinkeln liegt.

9. Vorrichtung nach Anspruch 1, dadurch gekennzeichnet, daß jeder Schleusenstation (8, 9) eine Beladestation (16, 17) und eine Magazinstation (18, 19) zugeordnet ist, daß zwischen jeder Beladestation und jeder Magazinstation eine Übergabeeinrichtung (20, 21) mit zwei parallelen Einbahn-Transportstraßen (20a, 20b; 21a, 21b) angeordnet ist.

10. Vorrichtung nach Anspruch 9, dadurch gekennzeichnet, daß jede Beladestation (16, 17) zwei Greifer (22, 23) aufweist, die in diametral entgegengesetzten Richtungen auf einer gemeinsamen Drehachse (24) befestigt sind, die in einer solchen Lage zur Übergabeeinrichtung (20, 21) einerseits und zur Schleusenstation (9, 8) andererseits angeordnet ist, daß mittels des einen Greifers (23) ein oberhalb der Schleusenstation (8, 9) befindliches Substrat (26a) und mittels des anderen Greifers (22) gleichzeitig ein oberhalb der Übergabeeinrichtung befindliches Substrat (26b) wahlweise erfaßbar oder absetzbar ist.

11. Vorrichtung nach Anspruch 1, dadurch gekennzeichnet, daß die Schleusenstation (8, 9) ein in senkrechter Richtungen abgedichtet gegenüber der Vakuumkammer (1) bewegliches Schleusenkammer-Oberteil (38) mit einem zylindrischen Innenraum (29) und mit je einer waagrechten oberen und unteren Dichtfläche (40a, 40b) aufweist, ferner einen angetriebenen, dem Oberteil (38) zugeordneten und dessen Innenraum (39) weitgehend ausfüllenden Verdrängerkörper (44) mit einem an seiner Oberkante befindlichen umlaufenden und beim Absenken auf die obere Dichtfläche (40a) des Oberteils (38) aufsetzbaren Dichtrand (45), ferner einen Antrieb, durch den die untere Dichtfläche (40b) des Oberteils nachfolgend abgedichtet auf der Oberseite des Substrathalters (6) absetzbar ist, weiterhin ein in senkrechter Richtung abgedichtet gegenüber der Vakuumkammer (1) bewegliches, zum Oberteil (38) koaxiales Schleusenkammer-Unterteil (51) mit einer oberen Dichtfläche (55), die abgedichtet an die Unterseite des Substrathalters (6) anpreßbar ist, derart, daß bei abgehobenen Verdrängerkörper der Raum zwischen Substrathalter (6) und Vakuumkammer gegenüber der Umgebungsluft abgedichtet ist, bei abgesenktem Verdrängerkörper (44) und evakuierter Schleusenkammer hingegen der Substrathalter frei gegenüber den Dichtflächen beweglich ist.

12. Vorrichtung nach Anspruch 11, dadurch gekennzeichnet, daß die Substrataufnahmen (63) rotationssymmetrisch ausgebildet und vertikal beweglich im Substrathalter (6) gelagert und durch Hubstangen (62, 78) zusammen mit den Substraten (26) anhebbar und absenkbar sind.

13. Vorrichtung nach den Ansprüchen 11 und 12, dadurch gekennzeichnet, daß im Schleusenkammer-Unterteil (51) koaxial zu diesem eine Hubstange (62) für die in der Schleusenstation (8) befindliche Substrataufnahme (63) angeordnet ist.

14. Vorrichtung nach den Ansprüchen 1 und 12, dadurch gekennzeichnet, daß die Beschichtungsstation (10, 11) eine auf der Vakuumkammer (1) angeordnete Kathodenkammer (77, 73) mit einer Zerstäubungskathode (67) mit einem Target (68) aufweist, dessen Zerstäubungsfläche (68a) dem Substrathalter (6) zugekehrt ist, daß zwischen dem Target und dem Substrathalter ein Maskenträger (76) mit einer Maske (80) angeordnet ist, und daß unterhalb der Vakuumkammer (1) eine Hubeinrichtung (77) mit einer den Kammerboden (3) abgedichtet durchdringenden Hubstange (78) angeordnet ist, durch die das Substrat (20 mittels der Substrataufnahme konzentrisch an die Maske (80) anpreßbar ist.

**Claims**

1. A device operating according to the carousel principle for coating substrates, comprising a vacuum chamber and a substrate holder, which is rotatably arranged in the vacuum chamber, which comprises a plurality of substrate receiving elements distributed equidistantly and in a circular arrangement and by means of which a corresponding number of substrates can be transported via a drive step-by-step along a circular path from a lock station through at least one coating station to a second lock station, characterised in that, in the circumferential direction of the rotatable substrate holder (6), the vacuum chamber (1) comprises two lock stations (8, 9) and two coating stations (10, 11) arranged one behind the other in each case, and in that the step width of the drive (36) on the one hand and the angular position of each coating station (10 or 11) relative to its associated lock station (8 or 9) in relation to the axis of rotation of the substrate holder (6) on the other hand are selected in such a manner that the same coating station (10 or 11) is associated via the step-by-step movement of a particular substrate receiving element (63) with the same lock station (8 or 9) in each case.

2.   A device according to claim 1, characterised in that the substrates coated in the first coating station (10) in the direction of transportation can be inserted and removed through the lock station (8) which is also first in the direction of transportation and the substrates coated in the second coating station (11) in the direction of transportation can be inserted and removed through the last lock station (9) in each case.

3.   A device according to claim 1, characterised in that the step width of the drive (36) is twice the pitch angle for the substrate receiving elements.

4.   A device according to claim 3, characterised in that the distance between the lock stations (8, 9) in the circumferential direction is an odd-numbered multiple of the pitch angle.

5.   A device according to claim 3, characterised in that the distance between the coating stations (10, 11) in the circumferential direction is an odd-numbered multiple of the pitch angle.

6.   A device according to claim 1, characterised in that the angular distance between the two lock stations (8, 9) is three times the pitch angle.

7.   A device according to claim 1, characterised in that the angular distance between the two coating stations (10, 11) is five times the pitch angle.

8.   A device according to claim 1, characterised in that the angular distance between the last coating station (11) in the direction of transportation and the first lock station (8) in the direction of transportation is five times the pitch angle.

9.   A device according to claim 1, characterised in that a loading station (16, 17) and a magazine station (18, 19) are associated with each lock station (8, 9) and a transfer device (20, 21) having two parallel one-way conveyor lines (20a, 20b; 21a, 21b) is associated with each loading station and each magazine station.

10.  A device according to claim 9, characterised in that each loading station (16, 17) comprises two jaws (22, 23), which are secured in diametrically opposite directions on a common axis of rotation (24), which is arranged in such a position relative to the transfer device (20, 21) on the one hand and the lock station (9, 8) on the other hand that a substrate (26a) lying above the lock station (8, 9) can be optionally gripped or deposited by the first jaw (23) and a substrate (26b) lying above the transfer device can be simultaneously optionally gripped or deposited by the second jaw (22).

11.  A device according to claim 1, characterised in that the lock station (8, 9) comprises an upper lock station section (38), which is displaceable in the vertical direction sealed relative to the vacuum chamber (1) and comprises a cylindrical inner chamber (39) and a horizontal upper and lower sealing surface (40a, 40b) in each case, a driven displacement element (44) associated with the upper section (38) and extensively filling the inner chamber (39) of said upper section and comprising a circumferential sealing edge (45), which is arranged on the upper edge of the displacement element (44) and upon lowering comes to rest on the upper sealing surface (40a) of the upper section (38), a drive, by means of which the lower sealing surface (40b) of the upper section can be subsequently deposited onto the upper side of the substrate holder (6) in a sealing-tight manner, a lower lock chamber section (51), which is displaceable in the vertical direction sealed relative to the vacuum chamber (1) and is coaxial to the upper section (38), with an upper sealing surface (55), which can be pressed in a sealing-tight manner against the underside of the substrate holder (6) in such a manner that, when the displacement element is raised, the space between the substrate holder (6) and the vacuum chamber is sealed relative to the surrounding air, whereas when the displacement element (44) is lowered and the lock chamber evacuated, the substrate holder can be moved freely relative to the sealing surfaces.

12.  A device according to claim 11, characterised in that the substrate receiving elements (63) are rotationally symmetrical, are mounted in the substrate holder (6) so as to be vertically displaceable and can be raised and lowered together with the substrates (26) by means of lifting rods (62, 78).

13.  A device according to claims 11 and 12, characterised in that a lifting rod (62) for the substrate receiving element (63) lying in the lock station (8) is arranged in the lower lock chamber section (51) coaxial to said section.

14. A device according to claims 1 and 12, characterised in that the coating station (10, 11) comprises a cathode chamber (77, 73) arranged on the vacuum chamber (1) and having an atomising cathode (67) with a target (68), whose atomising surface (68a) faces the substrate holder (6), and in that a mask support (76) with a mask (80) is arranged between the target and the substrate holder and in that a lifting device (77) with a lifting rod (78) penetrating the chamber base (3) in a sealing-tight manner is arranged beneath the vacuum chamber (1), by means of which lifting device (77) the substrate (26) can be pressed via the substrate holder concentrically onto the mask (80).

## Revendications

1. Dispositif selon le principe du carrousel, pour revêtir des substrats, comportant une chambre à vide et, agencé dans celle-ci, un porte-substrats capable de tourner, lequel présente, en répartition équidistante et en agencement circulaire, plusieurs réceptacles à substrat et par lequel un nombre correspondant de substrats peut être transporté, au moyen d'un entraînement, pas-à-pas sur une trajectoire circulaire, d'un poste-sas à un poste-sas en passant par au moins un poste de revêtement, caractérisé par le fait que la chambre à vide (1) présente, sur la direction circonférentielle du porte-substrats tournant (6), deux postes-sas (8, 9) et deux postes de revêtement (10, 11), à chaque fois l'un à la suite de l'autre, et par le fait que le pas de l'entraînement (36), d'une part, et la position angulaire de chaque poste de revêtement (10, 11) par rapport au poste-sas (8, 9) qui lui est conjugué, en se référant à l'axe de rotation du porte-substrats (6), d'autre part, sont choisis de manière telle qu'un seul et même poste de revêtement (10, 11) soit conjugué à chaque fois à un seul et même poste-sas (8, 9), par le mouvement pas-à-pas d'un réceptacle à substrat (63) déterminé à chaque fois.

2. Dispositif selon revendication 1, caractérisé par le fait que les substrats revêtus dans le poste de revêtement (10) le plus en avant dans la direction du transport peuvent être ensassés et dessassés par le poste-sas (8) se trouvant également le plus en avant dans la direction du transport, et les substrats revêtus dans le poste de revêtement (11) le plus en arrière dans la direction du transport peuvent être ensassés et dessassés par le poste-sas (9) à chaque fois le plus en arrière.

3. Dispositif selon revendication 1, caractérisé par le fait que le pas de l'entraînement (36) est le double de l'angle de division pour les réceptacles à substrat.

4. Dispositif selon revendication 3, caractérisé par le fait que l'intervalle entre postes-sas (8, 9), en direction circonférentielle, est un multiple impair de l'angle de division.

5. Dispositif selon revendication 3, caractérisé par le fait que l'intervalle entre postes de revêtement, en direction circonférentielle, est un multiple impair de l'angle de division.

6. Dispositif selon revendication 1, caractérisé par le fait que les deux postes-sas (8, 9) sont séparés l'un de l'autre par un intervalle angulaire de 3 angles de division.

7. Dispositif selon revendication 1, caractérisé par le fait que les deux postes de revêtement (10, 11) sont séparés l'un de l'autre par un intervalle angulaire de cinq angles de division.

8. Dispositif selon revendication 1, caractérisé par le fait qu'il y a un intervalle angulaire de cinq angles de division entre le poste de revêtement (11) qui est le dernier dans la direction du transport et le poste-sas (8) qui est le premier dans la direction du transport.

9. Dispositif selon revendication 1, caractérisé par le fait qu'à chaque poste-sas (8, 9) sont conjugués un poste de chargement (16, 17) et un poste-magasin (18, 19), par le fait qu'entre chaque poste de chargement et chaque poste-magasin est agencé un dispositif de transfert (20, 21) avec deux chemins de transport à une seule voie parallèles (20a, 20b; 21a, 21b).

10. Dispositif selon revendication 9, caractérisé par le fait que chaque poste de chargement (16, 17) présente deux organes de saisie (22, 23) qui sont fixés dans des directions diamétralement opposées, sur un axe de rotation commun (24), lequel est agencé dans une position telle par rapport au dispositif de transfert (20, 21), d'une part, et par rapport au poste-sas (9, 8) d'autre part, qu'un substrat (26a) se trouvant au-dessus du poste-sas (8, 9) puisse être saisi ou déposé, au choix, au moyen du premier organe de saisie (23), et qu'un substrat (26b) se trouvant au-dessus du dispositif de transfert puisse en même temps être saisi ou déposé, au choix, au moyen de l'autre organe de saisie (22).

**11.** Dispositif selon revendication 1, caractérisé par le fait que le poste-sas (8, 9) présente une partie supérieure de chambre de sas (38) qui est mobile en direction verticale et étanchée par rapport à la chambre à vide (1) et qui comporte un volume intérieur cylindrique (39) et une surface d'étanchéité horizontale supérieure (40a) et une surface d'étanchéité inférieure (40b), en outre un corps refouleur (44) entraîné, conjugué à la partie supérieure (38) et remplissant substantiellement son volume intérieur (39), doté d'un bord d'étanchéité (45) périmétrique se trouvant sur son arête supérieure et applicable sur la surface d'étanchéité supérieure (40a) de la partie supérieure (38) lors de la descente, en outre un entraînement par lequel la surface d'étanchéité inférieure (40b) de la partie supérieure peut ensuite être déposée avec étanchéité sur le côté supérieur du porte-substrats (6), en outre une partie inférieure de chambre de sas (51) coaxiale à la partie supérieure (38), mobile en direction verticale et étanchée par rapport à la chambre à vide (1), cette partie inférieure ayant une surface d'étanchéité supérieure (55) qui peut être appuyée avec étanchéité contre le côté inférieur du porte-substrats (6), de manière telle que lorsque le corps refouleur est relevé le volume entre porte-substrats (6) et chambre à vide se trouve étanché par rapport à l'air environnant, et que, lorsque le corps refouleur (44) est abaissé et que la chambre de sas est évacuée, le porte-substrats soit par contre librement mobile par rapport aux surfaces d'étanchéité.

**12.** Dispositif selon revendication 11, caractérisé par le fait que les réceptacles à substrat (63) ont une configuration à symétrie de rotation et sont montés avec possibilité de déplacement vertical dans le porte-substrats (6) et peuvent être levés et abaissés conjointement avec les substrats (26) par des tiges de levage (62, 78).

**13.** Dispositif selon les revendications 11 et 12, caractérisé par le fait qu'une tige de levage (62) pour le réceptacle à substrat (63) se trouvant dans le poste-sas (8) est agencée dans la partie inférieure (51) de la chambre de sas, coaxialement à celle-ci.

**14.** Dispositif selon les revendications 1 et 12, caractérisé par le fait que le poste de revêtement (10, 11) présente, agencée sur la chambre à vide (1), une chambre cathodique (77, 73) avec une cathode de pulvérisation (67) avec une cible (68) dont la surface de pulvérisation (68a) est tournée vers le porte-substrats (6), par le fait qu'entre la cible et le porte-substrats est agencé un porte-masque (76) avec un masque (80), et par le fait qu'en dessous de la chambre à vide (1) est agencé un dispositif de levage (77) avec une tige de levage (78) traversant avec étanchéité le fond (3) de la chambre, tige par laquelle le substrat (20) peut être appuyé concentriquement contre le masque (80) au moyen du réceptacle à substrat.

FIG.1

# FIG. 2

FIG.3

**FIG. 4**

## FIG.5

## FIG.6

FIG.7